Europäisches Patentamt

European Patent Office

Office européen des brevets

(19)

(11) **EP 0 929 156 A2**

(12) **EUROPEAN PATENT APPLICATION**

(43) Date of publication:
14.07.1999 Bulletin 1999/28

(51) Int. Cl.$^6$: **H03L 7/087**

(21) Application number: 99100076.1

(22) Date of filing: 05.01.1999

(84) Designated Contracting States:
AT BE CH CY DE DK ES FI FR GB GR IE IT LI LU
MC NL PT SE
Designated Extension States:
AL LT LV MK RO SI

(30) Priority: 06.01.1998 JP 1201598

(71) Applicant: NEC CORPORATION
Tokyo (JP)

(72) Inventor:
Kawaguchi, Manabu
c/o NEC Corporation
Tokyo (JP)

(74) Representative:
Glawe, Delfs, Moll & Partner
Patentanwälte
Postfach 26 01 62
80058 München (DE)

(54) **Phase locked loop circuit**

(57) Frequencies and phase differences between the oscillation output of a voltage control oscillation means and a reference signal are compared by a first comparison means, and a first charging pump charges and discharges a time constant circuit based on the comparison result performed by the first comparison means. Frequencies and phase differences between the oscillation output of the voltage control oscillation means and the reference signal are also compared by a second comparison means having a buffer amplifying the output of a flip-flop circuit constituting the first comparison circuit, and a second charging pump charges and discharges the time constant circuit based on the comparison result performed by the second comparison means. The gain of the phase difference versus outputting voltage characteristic of the second comparison means is higher than that of the first comparison means, and the second comparison means has a dead zone in said phase difference versus outputting voltage characteristic. On the other hand, a first delaying circuit for resolving a dead zone is inserted into the first comparison means.

FIG.1

## Description

## Background of the Invention

The present invention relates to a phase locked loop circuit.

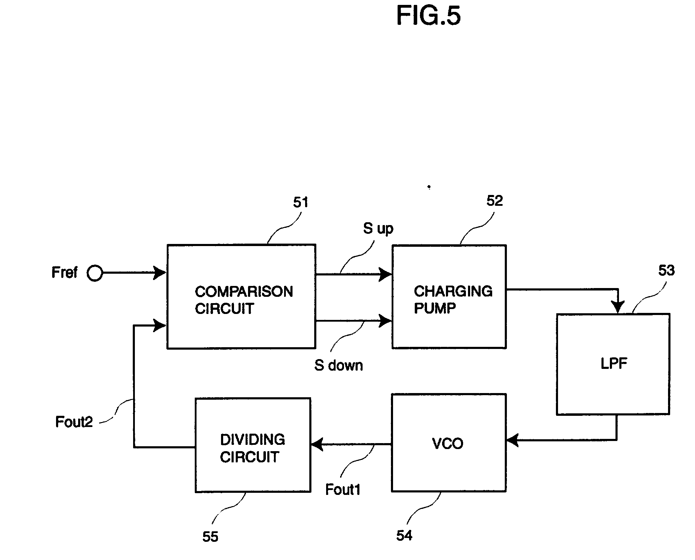

Fig.5 is a block diagram showing an example of a conventional PLL (Phase Locked Loop) circuit. As shown in Fig.5, generally, a PLL circuit which is a feedback circuit is composed of the comparison circuit (phase frequency comparison circuit) 51, the charging pump 52, the LPF (Low Pass Filter) 53, the VCO (Voltage Controlled Oscillator) 54, and the dividing circuit 55.

The comparison circuit 51 compares phases and frequencies between a reference signal Fref inputted from the external and a signal Fout2 outputted from the dividing circuit 55, and outputs a control signal Sup and a control signal Sdown whose amplitudes have a tendency to reduce these differences in proportion to the differences between those phases and frequencies.

The charging pump 52 performs charging and discharging a control voltage Vcnt by way of the LPF 53 on the basis of the control signal Sup and control signal Sdown outputted from the comparison circuit 51.

The LPF 53 performs direct current averaging of the electric potential changes of the control voltage Vcnt generated by charging and discharging current from the charging pump 52.

The VCO 54 outputs an oscillation pulse Fout1 having a frequency in proportion to the inputted control voltage Vcnt. The dividing circuit 55 which is composed of a counter and a divider or the like, divides the frequency of the oscillation pulse Fout1 outputted by the VCO 54 into a frequency of 1/N, and outputs a signal Fout2.

The PLL circuit compares frequencies and phases between the reference signal Fref and the signal Fout2 of a frequency of 1/N into which the oscillation pulse Fout1 outputted by the VCO is divided, and the signal Fout2 which has been in synchronization with the reference signal Fref with respect to frequency and phase is obtained by performing a feedback circuit operation going toward the direction of reducing the differences of those frequencies and phases.

Then, as an output of the VCO 54, the frequency of the oscillation pulse Fout1 which is in synchronization with the inputted reference signal Fref and which also has been N-fold multiplied by the reference signal Fref (= F ref x N) can be obtained.

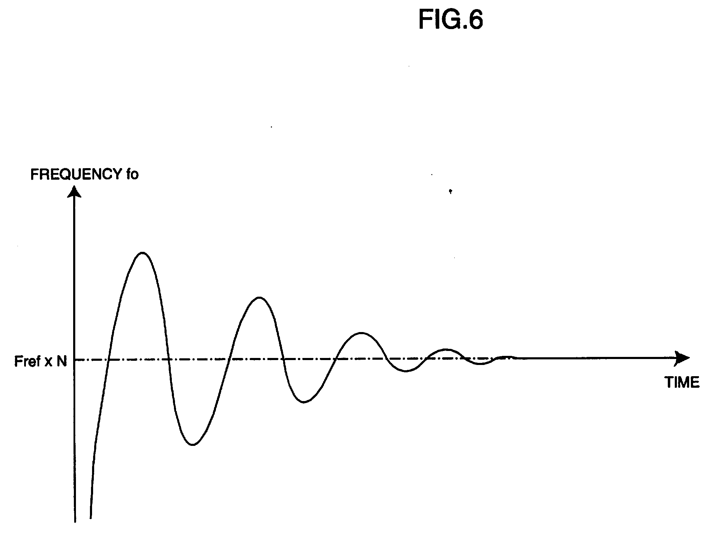

Fig.6 is a graphical presentation showing a phase frequency characteristic of the synchronizing operation of the PLL circuit.

First, at the time when the PLL circuit starts an operation, the VCO 54 is oscillating at the self-propelled oscillation frequency f0 that is determined by the circuit constant. In this condition, the output signal Fout2 is much different in comparison with the reference signal Fref with respect to both phase and frequency.

The comparison circuit 51 compares the reference signal Fref with the signal Fout2, and outputs a control signal Sup or a control signal Sdown which has a tendency to go toward the direction of reducing that difference.

That is to say, in the case where the phase of the signal Fout2 is delayed in comparison with that of the reference signal Fref, or in the case where the frequency of the signal Fout2 is lower than that of a signal Fref, a control signal Sup which has a tendency to make the frequency higher is outputted by the comparison circuit 51 to the feedback circuit constituting the PLL circuit.

On the contrary, in the case where the phase of the signal Fout2 goes ahead of that of the reference signal Fref, or in the case where the frequency of the signal Fout2 is higher than that of the signal Fref, the comparison circuit 51 outputs a control signal Sdown making the frequency lower.

Thus, the oscillation frequency of the VCO 54 is controlled by the control signal Sup and the control signal Sdown which is in proportional to an error signal between the reference signal Fref and the signal Fout1 determined by the comparison circuit 51 through the medium of the charging pump 52 and the LPF 53.

An oscillation pulse Fout1 outputted by this VCO 54 is fed back to the comparison circuit 51 by way of the dividing circuit 55. Therefore, the signal Fout2 outputted by the dividing circuit 55 is gradually getting closer to the reference signal Fref with respect to phase and frequency, and then, in a short time, becomes stable in a state of the phase and the frequency of the signal Fout2 being equal to those of the signal Fref and the signal Fout2 continuing to oscillate.

In this manner, a state where phases and frequencies are equal each other is called a state of being in synchronization or a state of being locked.

Moreover, operations in series from a starting operation until an operation for being in synchronization are called "retracting operation", "locked operation" or "synchronizing operation", and the time until synchronization is obtained is called a "locked time", "locked up time" or "retraction time".

This type of PLL circuit is widely used in the communication field and the logic processing field and the like, since this is used as a basic clock signal on circuit operations, a PLL circuit which is locked in a shorter time is required.

Then, as examples of shortening the locked time of a PLL (Phase Locked Loop) circuit, there are the method of making the gain of the connection between the comparison circuit and the charging pump larger, the method of making the gain of the LPF (Low Pass Filter) larger, or the method of making the gain of the VCO (Voltage Controlled Oscillator) larger.

However, in a conventional PLL circuit, when the frequency sensitivity is increased in order to enhance the locked up characteristic (retraction characteristic), the jitter (synchronization variation) characteristic of an outputting signal becomes also increased.

On the other hand, making the frequency sensitivity lower in order to lower a jitter characteristic of an outputting signal results in an increase of the locked up characteristic.

Therefore, it was difficult to design a PLL circuit having a low jitter characteristic and a high speed locked up characteristic at the same time.

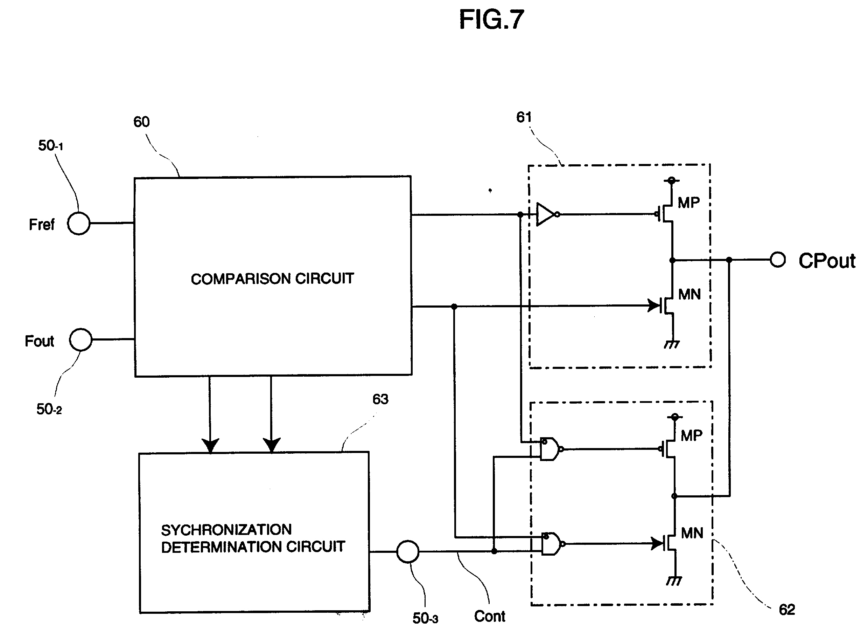

Up to now, some design efforts for making the jitter characteristic lower and operating retraction at higher speed of a PLL circuit have been performed. As a representative example, there is an example of optimizing the loop constant of a PLL circuit and using gain switching of a dynamic characteristic. Fig.7 is a block diagram showing a constitution of this type of PLL circuit as also shown in Japanese Published Unexamined Utility Model Application No. H1-65527.

In the example shown in Fig.7, a plurality of comparison circuits - charging pumps are used, the dynamic characteristic of the PLL circuit is controlled by changing outputting gain characteristics of comparison circuits - charging pumps at the time of being locked up and during the usual operation.

In the example shown in Fig. 7, a control signal Sup and a control signal Sdown which are outputted from the comparison circuit 60 are inputted into two (2) charging pumps, specifically, the charging pump 61 and the charging pump 62.

A signal Cont outputted from the synchronization determination circuit 63 makes only one of two (2) charging pumps, specifically, only one of the charging pump 61 and the charging pump 62, active, selects an outputting to the LPF (not shown) and switches to the LPF.

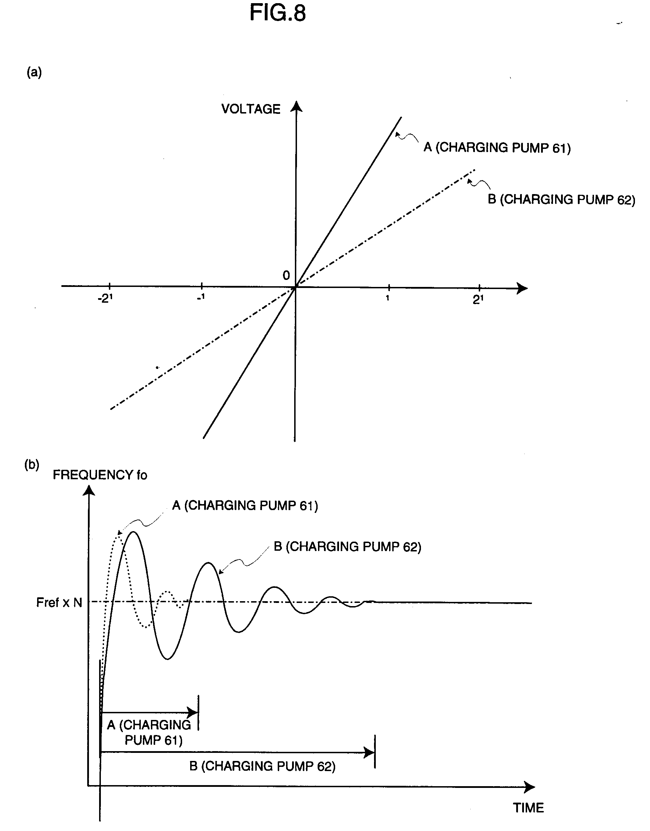

Fig.8 is a graphical presentation showing outputting characteristics of comparison circuits - charging pumps (Fig.8 (a)), and phase frequency characteristics of comparison circuits - charging pumps (Fig.8 (b)). It should be noted that lines A (solid in (a) and dotted in (b)) in Fig.8 are the outputting characteristic of the charging pump 61 and lines B (chain in (a) and solid in (b)) in Fig.8 are the outputting characteristic of the charging pump 62.

For the phase difference $\Delta \phi$ between the reference signal Fref inputted into the comparison circuit 60 by way of the terminal 50-1 and the signal Fout inputted from the VCO (presentation omitted) or the dividing circuit, a voltage CPout is outputted from the charging pump 61 or the charging pump 62. Specifically, a voltage CPout is outputted which is proportional to the phase difference $\Delta \phi$ and which has a magnitude of voltage sufficient to reduce the difference.

In this PLL circuit, the charging pump 61 whose gain characteristic (outputting voltage versus phase difference $\Delta \phi$) is larger is selected by the control signal Cont in the retraction process, and after being locked, the control signal Cont switches to the charging pump 62 whose gain is smaller.

Specifically, a high speed locked characteristic is utilized by making the gain of the comparison circuit - the charging pump larger in the locked up process, and after being locked, a lower jitter characteristic is achieved by switching to the comparison circuit - the charging pump whose gain is smaller.

In this control process, the synchronization determination circuit 63 determines whether the PLL circuit is in a locked up process or locked up and a control signal which is controlled on the basis of this determination results or a control signal inputted from the external are used.

However, as described above, in a conventional PLL circuit which switches between gains, there are problems such as an increase of the number of the terminals and an enlargement of the circuit scale.

**Summary of the Invention**

It is an object of the present invention, in consideration of the background described above, to provide a PLL (Phase Locked Loop) circuit having a high speed locked characteristic and a low jitter characteristic at the same time without enlargement of a circuit scale or without increasing the number of terminals to which control signals and the like are to be provided from the external.

An object of the present invention described above is to provide a PLL circuit composed of a feedback circuit controlling the frequency of voltage control oscillation means by way of a time constant circuit on the basis of an oscillation output of the foregoing voltage control oscillation means and a reference signal. The objective is achieved by providing the PLL circuit which comprises first comparison means for comparing frequencies and phase differences between the oscillation output of the voltage control oscillation means and the reference signal, a first charging pump charging and discharging the foregoing time constant circuit on the basis of the comparison results performed by the first comparison means, second comparison means for comparing frequencies and phase differences between the oscillation output of the voltage control oscillation means and the reference signal, and a second charging pump charging and discharging the time constant circuit on the basis of the comparison results performed by the second comparison means.

It should be noted that the second comparison means has a buffer amplifying an output of a flip-flop circuit constituting the first comparison circuit. Moreover, also noted, the PLL circuit is constituted so that the gain of the phase difference versus outputting voltage characteristic of the second comparison means and the second charging pump is higher than that of the first comparison means and the first charging pump.

Moreover, the second comparison means and the second charging pump are characterized in that they have a dead zone in the phase difference versus outputting voltage characteristic.

Moreover, the first comparison means is characterized in that it has a delaying circuit for resolving a dead zone.

Furthermore, the second comparison means is characterized in that it has delaying means for adjusting the width of the dead zone.

Moreover, the second delaying means is characterized in that it broadens the width of the dead zone of the second comparison means by making the delaying time larger.

Moreover, the first comparison means and the second comparison means are characterized in that an inputted oscillation output of the voltage control oscillation means and the reference signal are provided to the first comparison means and to the second comparison means, respectively.

Furthermore, the first comparison means and the first charging pump, the second comparison means and the second charging pump are characterized in that they have a dead zone in the phase difference versus outputting voltage characteristic, respectively. Still more, the first comparison means is characterized in that it has a third delaying circuit for resolving a dead zone.

According to the present invention, frequencies and phase differences between an oscillation output of voltage control oscillation means and a reference signal are compared by the first comparison means, the first charging pump charges and discharges the time constant circuit on the basis of the comparison results performed by the first comparison means, the second comparison means having a buffer amplifying an output of a flip-flop circuit constituting the first comparison circuit comparing frequencies and phase differences between the oscillation output of the voltage control oscillation means and the reference signal, the second charging pump charges and discharges the time constant circuit on the basis of the comparison results performed by the second comparison means, the gain of the phase difference versus outputting voltage characteristic of the second comparison means and the second charging pump is higher than that of the first comparison means and the first charging pump, and in the case where the second comparison means and the second charging pump have a dead zone in the phase difference versus outputting voltage characteristic, a first delaying circuit for resolving the dead zone is inserted into the first comparison means.

Moreover, second delaying means for adjusting the width of a dead zone by making the delaying time larger is inserted into the second comparison means.

## Brief Description of the Drawings

These and other objects, features and advantages of the present invention will become more apparent upon reading of the following description and drawings, in which:

Fig. 1 is a circuit diagram showing a PLL (Phase Locked Loop) circuit of a first embodiment of the present invention.

Fig. 2 is a characteristic graphical presentation showing the characteristic of the comparison circuit -charging pump shown in Fig. 1.

Fig. 3 is a circuit diagram showing a PLL circuit of a second embodiment of the present invention.

Fig. 4 is a circuit diagram showing a PLL circuit of a third embodiment of the present invention.

Fig. 5 is a block diagram showing an example of a conventional PLL circuit.

Fig. 6 is a graphical presentation showing the phase frequency characteristic of the synchronization operation of the PLL circuit shown in Fig. 5.

Fig. 7 is a block diagram showing an example of a PLL circuit optimizing the loop constant and using switching between gains of dynamic characteristic.

Fig. 8 is a graphical presentation showing the outputting characteristic and phase frequency characteristic of a comparison circuit and a charging pump.

## Description of the Embodiments

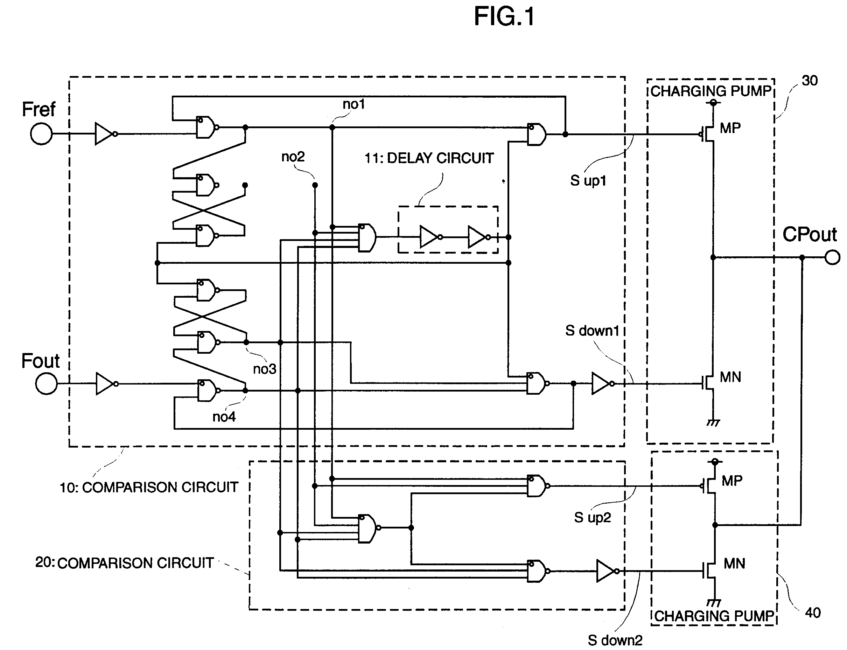

Fig. 1 is a circuit diagram showing a PLL circuit of a first embodiment of the present invention. It should be noted that the stucture of the feedback circuit of a PLL circuit to which the embodiment of the present invention is applied is similar to the conventional one. Therefore the presentation of the diagram and the description about the feedback circuit in detail are omitted.

In Fig. 1, reference numerals 10 and 20 denote comparison circuits. Of these comparison circuits, the comparison circuit 10, to which an oscillation signal Fout outputted from the VCO (not shown) is inputted, has a characteristic of without dead zone, comparison circuits 10 and 20 are circuits using logic gates and FF (flip-flop) circuits and the like, as also shown in, for example, United States Patent No.4,281,259 and the IEEE reference Vol. CE-27, No.3, August, pp.220-226, and others.

The delaying circuit 11 in the comparison circuit 10 is a delaying circuit composed of an inverter, and resolves dead zones described above.

The comparison circuit 20 is allowed to have a characteristic having a dead zone, and receives input signals from the points nO1, nO2 and nO4 within the circuit of the comparison circuit 10 as shown in Fig. 1.

A control signal Sup1 and a control signal Sdown1 outputted from the comparison circuit 10 are provided to a charging pump 30. On the other hand, a control signal Sup2 and a control signal Sdown2 outputted from the comparison circuit 20 are provided to a charging pump 40.

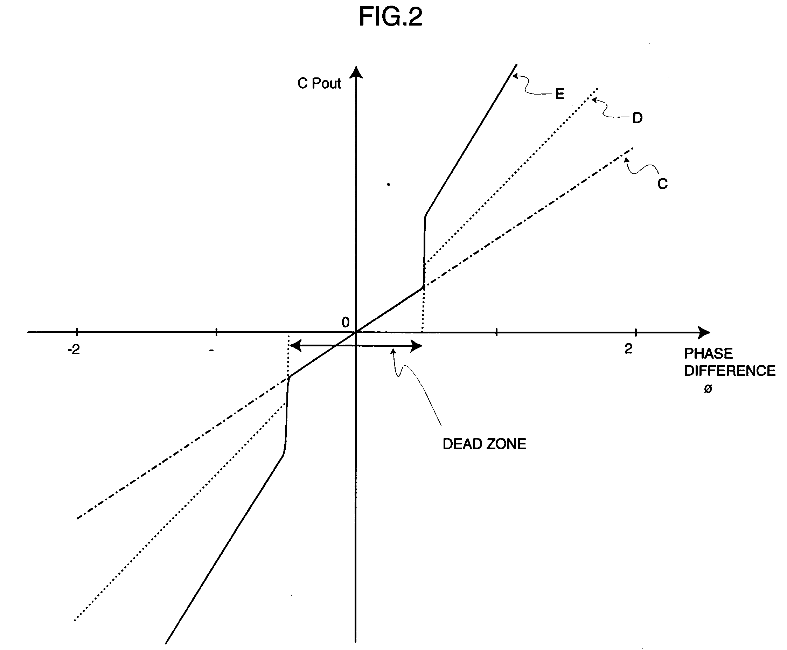

Fig. 2 is a characteristic graphical presentation showing the characteristic of the outputting voltage of the comparison circuit - the charging pump shown in Fig. 1 versus the phase error $\Delta \phi$ between the reference signal Fref and the oscillating signal Fout which is the compared signal.

Line C (chain) in Fig. 2 denotes a characteristic with respect to the connection between the comparison circuit 10 and the charging pump 30, line D (dotted) denotes a characteristic with respect to the connection between the comparison circuit 20 and the charging pump 40, and line B (solid) denotes the sum of line C (chain) and line D (dotted).

In the circuit shown in Fig. 1, as described above, the comparison circuit 20 has a dead zone. Thus, the gain of the phase error $\Delta \phi$ versus outputting voltage characteristic of the comparison circuit 10 having no dead zone is set lower in comparison with the characteristic of the comparison circuit 20.

The inputted reference signal Fref and the oscillation signal Fout are provided to the comparison circuit 10 and signals based on these signals Fref and Fout are provided in parallel to the comparison circuit 20. As a result, a voltage CPout which is the sum of the output of the charging pump 30 and the output of the charging pump 40 is outputted according to line B shown in Fig. 2.

The operation of the present embodiment of the invention will be described below.

In the case where the phase difference between the inputted reference signal Fref and the oscillation signal Fout is larger than the width of the dead zone, that is to say, large enough to go beyond the dead zone, a large magnitude of voltage, with a gain which is the sum of the characteristic of the comparison circuit 10 and the characteristic of the comparison circuit 20, is outputted.

On the other hand, in the case where the phase difference between the two inputting signals Fref and Fout is within the width of the dead zone, a voltage of a small gain determined by the characteristic of the comparison circuit 10 is outputted.

Specifically, in the case where a phase difference between the two inputting signals Fref and Fout is large, since the gain of the outputting voltage characteristic is large, it becomes a high speed locking characteristic.

Moreover, in a state where the phase difference becomes smaller, and in a state of being locked, since the gain in the phase difference versus outputting voltage characteristic is small, a micro-sized control of the phase frequency characteristic is performed, and it becomes a low jitter (low noise outputting) characteristic.

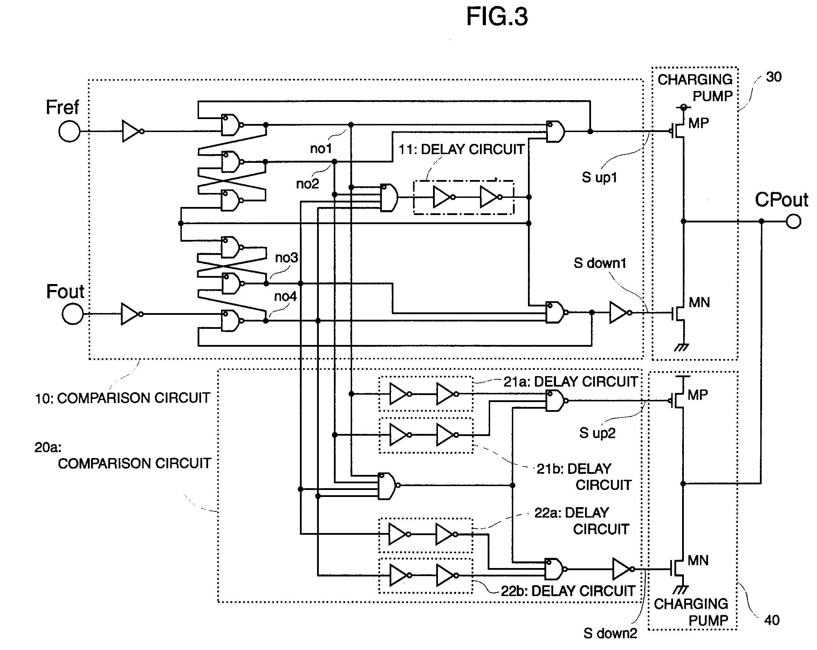

Fig. 3 is a circuit diagram showing a PLL circuit of a second embodiment of the invention. It should be noted that the presentation of diagram and description in detail are omitted since the structure of the feedback circuit of the PLL circuit also in the present embodiment is similar to conventional ones.

Moreover, in Fig. 3, the same reference numerals as in Fig. 1 are applied and their description is omitted.

In the comparison circuit 20a shown in Fig. 3, delaying circuits, 21a, 21b, 22a and 22b for adjusting the width of dead zones are inserted.

The width of a dead zone can be broadened by making the delaying times of these delaying circuits 21a, 21b, 22a and 22b larger.

Specifically, in the present embodiment an area of low jitter characteristic of inputs can be controlled. As for the phase error versus outputting voltage characteristic, the gain or the like are equal except that, for example, the setting of a width of a dead zone as shown in Fig. 2 which can be altered. Moreover, operation in detail is the same as in Fig. 1 and Fig. 2.

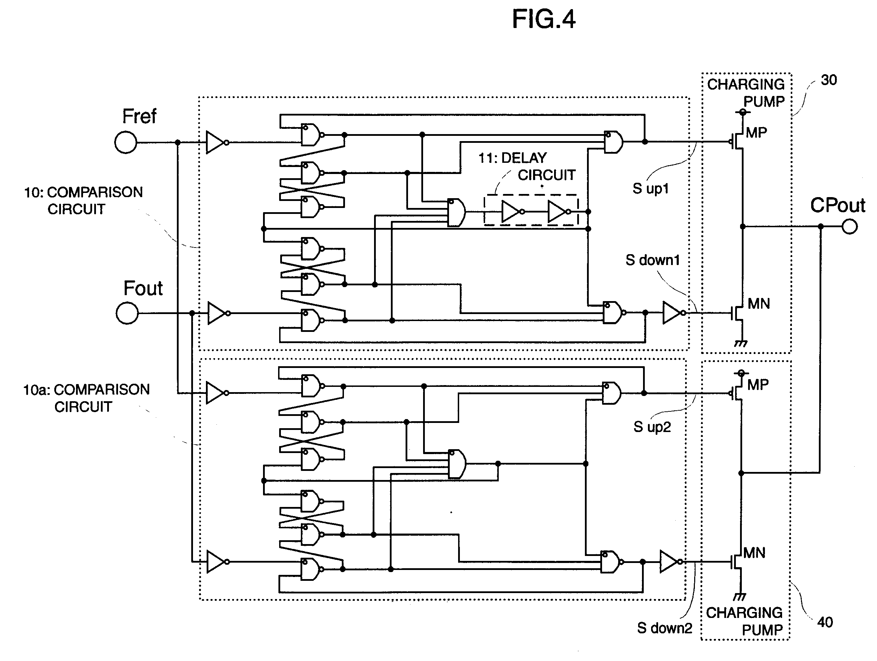

Fig. 4 is a circuit diagram showing a PLL circuit of the third embodiment of the invention. It should be noted that presentation of diagram and description in detail are omitted since the structure of the feedback circuit of the PLL circuit also in the present embodiment is similar to conventional ones.

Moreover, also in Fig. 4, since the same reference numerals as in Fig. 1 or in Fig. 3 are applied in their description is omitted.

In Fig. 4, reference numeral 10a denotes a comparison circuit, which is constituted in the same manner as comparison circuit 10 except that the comparison circuit 10a does not have the delaying circuit 11.

In the present embodiment the very same reference signal Fref is provided to the comparison circuit 10 and to the comparison circuit 10a. Moreover, an oscillation signal Fout is also provided to the comparison circuit 10 and to the comparison circuit 10a.

As for operation of the present embodiment in detail, this is also the same as indicated in Fig. 1 or in Fig. 3, but it can be distinguished in that the enlargement of the circuit scale of the present embodiment is less.

As described above, according to the present invention, frequencies and phase differences between an oscillation output of voltage control oscillation means and a reference signal are compared by the first comparison means, the first charging pump charges and discharges the time constant circuit on the basis of the comparison results performed by the first comparison means, the second comparison means having a buffer amplifying an output of a flip-flop circuit constituting the first comparison circuit comparing frequencies and phase differences between the oscillation output of voltage control oscillation means and the reference signal; the second charging pump charges and discharges the time constant circuit on the basis of the comparison results performed by the second comparison means; the gain of the phase difference versus outputting voltage characteristic of the second comparison means and the second charging pump is higher than that of the first comparison means and the first charging pump; in the case where the second comparison means and the second charging pump have a dead zone in the phase difference versus outputting voltage characteristic, a first delaying circuit for resolving the dead zone is inserted into the first comparison circuit. Moreover, since a second delaying means can be inserted into the second comparison means for adjusting the width of the dead zone broadened by making the delaying time larger, the effect that the PLL circuit has a high speed locking characteristic and a low jitter characteristic at the same time can be realized without a considerable enlargement of the circuit scale or without an accompanying increase of the number of the terminals to which control signals and the like are to be provided.

**Claims**

1.  A PLL (Phase Locked Loop) circuit composed of a feedback circuit controlling the frequency of voltage control oscillation means by way of a time constant circuit based on an oscillation output (Fout) of said voltage control oscillation means and a reference signal (Fref), said PLL circuit comprising:

    first comparison means (10) for comparing frequencies and phase differences between the oscillation output of said voltage control oscillation means and said reference signal;
    a first charging pump (30) charging and discharging said time constant circuit based on the comparison result performed by said first comparison means;
    second comparison means (20) for comparing frequencies and phase differences between the oscillation output of said voltage control oscillation means and said reference signal; and
    a second charging pump (40) charging and discharging said time constant circuit based on the comparison result performed by said second comparison means.

2.  A PLL circuit as claimed in claim 1, wherein said second comparison means (20) has a buffer amplifying the output of a flip-flop circuit constituting said first comparison circuit (10), and the gain of the phase difference versus outputting voltage characteristic of said second comparison means (20) and said second charging pump (40) is higher than the gain of the phase difference versus outputting voltage characteristic of said first comparison means (10) and said first charging pump (30).

3.  PLL circuit as claimed in any one of claim 1 or claim 2, wherein said second comparison means (20) and said second charging pump (40) have a dead zone in the phase difference versus outputting voltage characteristic.

4.  A PLL circuit as claimed in claim 3, wherein said first comparison means (10) has a first delaying circuit (11) for resolving a dead zone.

5.  A PLL circuit as claimed in any one of claim 1 or claim 4, wherein said second comparison means (20a) has second delaying means (21a, 21b, 22a, and 22b) for adjusting the width of said dead zone.

6.  A PLL circuit as claimed in claim 5, wherein the width of said dead zone of said second comparison means is broadened by said second delaying means (21a, 21b, 22a, and 22b) by making the delaying times of said second delaying means (21a, 21b, 22a, and 22b) larger.

7.  A PLL circuit as claimed in claim 1, wherein the oscillation output of said voltage control oscillation means and said reference signal are inputted to said first comparison means (10) and to said second comparison means (20) respectively.

8.  A PLL circuit as claimed in claim 7, wherein said first comparison means (10) and first charging pump (30) as well as said second comparison means (10a) and second charging pump (40) each have a dead zone in the phase difference versus outputting voltage characteristic, respectively.

9.  A PLL circuit as claimed in claim 8, wherein said first comparison means (10) has a third delaying circuit (11) for resolving a dead zone.

10. A PLL circuit composed of a feedback circuit controlling the frequency of voltage control oscillation means by way of a time constant circuit based on the oscillation output of said voltage control oscillation means and a reference signal, said PLL circuit comprising:

    first comparison means (10) for comparing frequencies and phase differences between the oscillation output of said voltage control oscillation means and said reference signal and having no dead zone in the phase difference versus outputting voltage characteristic;
    a first charging pump (30) charging and discharging said time constant circuit based on the comparison result performed by said first comparison means;

second comparison means (20) for comparing frequencies and phase differences between the oscillation output of said voltage control oscillation means and said reference signal and having a dead zone in the phase difference versus outputting voltage characteristic; and

a second charging pump (40) charging and discharging said time constant circuit based on the comparison result performed by said second comparison means;

wherein said PLL circuit is constituted so that the gain of a phase difference versus outputting voltage characteristic of said second comparison means (20) and said second charging pump (40) is higher than the gain of a phase difference versus outputting voltage characteristic of said first comparison means (10) and said first charging pump (30), and

said voltage control oscillation means is controlled by the sum of the outputting voltage of said first charging pump (30) and the outputting voltage of said second charging pump (40).

11. A PLL circuit as claimed in claim 1 or claim 10, wherein said second comparison means (20a) has delaying means (21a, 21b, 22a, and 22b) for adjusting the width of said dead zone.

12. A PLL circuit as claimed in claim 11, wherein the width of said dead zone of said second comparison means is broadened by said delaying means (21a, 21b, 22a, and 22b) by making the delaying times of said delaying means (21a, 21b, 22a, and 22b) larger.

# FIG.1

CHARGING PUMP    30

Fref

no1

11: DELAY CIRCUIT

no2

S up1

MP

CPout

S down1

MN

10: COMPARISON CIRCUIT

no3

Fout

no4

20: COMPARISON CIRCUIT

CHARGING PUMP

S up2

MP

S down2

MN

CHARGING PUMP    40

EP 0 929 156 A2

FIG.2

EP 0 929 156 A2

# FIG.3

EP 0 929 156 A2

# FIG.4

EP 0 929 156 A2

# FIG.5

EP 0 929 156 A2

FIG.6

# FIG.7

COMPARISON CIRCUIT

SYCHRONIZATION DETERMINATION CIRCUIT

Fref

Fout

Cont

CPout

EP 0 929 156 A2

# FIG.8

(a)

VOLTAGE

A (CHARGING PUMP 61)

B (CHARGING PUMP 62)

0

$-2^1$    $-1$    $1$    $2^1$

(b)

FREQUENCY fo

A (CHARGING PUMP 61)

B (CHARGING PUMP 62)

Fref x N

A (CHARGING PUMP 61)

B (CHARGING PUMP 62)

TIME